# EUROPEAN PATENT SPECIFICATION

(11) **EP 4 531 232 B1**
(45) Date of publication and mention of the grant of the patent: **12.08.2026**
(21) Application number: 24164030.9
(22) Date of filing: 18.03.2024
(51) Int. Cl.: H02J 7/54, H02J 7/64

(54) **BATTERY CELL BALANCING DEVICE**
BATTERIEZELLENAUSGLEICHSVORRICHTUNG
DISPOSITIF D'ÉQUILIBRAGE DE CELLULES DE BATTERIE

(30) Priority: 27.09.2023 KR 20230130411
(43) Date of publication of application: 02.04.2025
(73) Proprietor: Hyundai Mobis Co., Ltd., Gangnam-gu Seoul 06141 (KR)
(72) Inventor: YANG, Su Hun, Yongin-si 16891 (KR)
(74) Representative: Vossius & Partner Patentanwälte Rechtsanwälte mbB

(56) References cited:
- US-A1- 2015 035 487
- US-A1- 2019 312 444

## Description

### BACKGROUND

### FIELD

Exemplary embodiments of the present invention relate to a cell balancing device, and more particularly, to a cell balancing device which suppresses the leakage current of a balancing switch that is connected in parallel to each of battery cells that are connected in series and blocks an operation of the balancing switch when a reverse voltage occurs in a corresponding channel.

### DISCUSSION OF THE BACKGROUND

Recently, interest is growing in electrical products which may be driven by using secondary cell batteries due to the exhaustion of fossil energy and environmental pollution attributable to the use of fossil energy. Accordingly, as the development of technologies, such as a mobile device, an electric vehicle (EV), a hybrid vehicle (HV), an energy storage system (ESS), and an uninterruptible power supply (UPS), and demands for the technologies are increased, the demand for the secondary cell battery as an energy source is suddenly increasing.

Such a secondary cell battery has been in the spotlight as an eco-friendly energy source and a new energy source for improving energy efficiency in that the secondary cell battery never generates by-products according to the use of energy in addition to a primary advantage capable of significantly reducing the use of fossil energy.

In particular, the secondary cell battery that is used in an electric vehicle, a hybrid vehicle, the ESS, and the UPS is constructed by connecting several battery cells in order to charge or discharge high output and high capacity power.

The battery cells of the secondary cell battery need to have ideally the same characteristic, but have deviations in the capacity, impedance, and internal resistance. Furthermore, a deviation between the battery cells is increased as the secondary cell battery is charged and discharged. Due to such a deviation between the battery cells, a specific battery cell has a reduced lifespan because the battery cell is overcharged or over-discharged. Furthermore, there is a problem in that even the lifespan of the secondary cell battery is reduced.

Accordingly, in order to improve the stability and lifespan of the battery cell, a balancing technology that uniformly maintains a voltage between the battery cells is applied to the secondary cell battery.

More specifically, a method of uniformly balancing the voltages of battery cells included in the secondary cell battery includes active balancing for raising the voltage of a battery cell having a relatively low voltage by supplying a charging current to the battery cell and passive balancing for dropping the voltage of a battery cell having a relatively high voltage by discharging the battery cell.

The background technology of the present disclosure was disclosed in Korean Patent Application Publication No. 10-2018-0013574 (February 7, 2018, entitled "APPARATUS AND METHOD FOR BALANCING BATTERY").

US 2015/035487 A1 relates to an equalization device for an assembled battery including multiple battery cells connected in series.

US 2019/312444 A1 relates to a balance circuit for a set of battery cells includes a set of switch circuits and control circuitry coupled to the switch circuits.

### SUMMARY

In a cell balancing device, one channel is constructed for each of battery cells that are connected in series. A balancing switch is connected in parallel to the battery cell. The battery cells and a balancing resistor are interposed between the upper pin and lower pin of the balancing switch. The cell balancing device performs a cell balancing operation by an on/off operation of the balancing switch.

In this case, the upper pin maintains a higher voltage than the lower pin. However, if a bus bar having a resistance component is interposed between the battery cells that are connected in series, a reverse voltage occurs in a corresponding channel because a lower voltage is applied to the upper pin than to the lower pin.

If the reverse voltage occurs as described above, there is a problem in that the leakage current may occur in the balancing switch or a failure of the balancing switch may occur. Furthermore, there is a problem in that an element that constitutes a driver circuit for driving the balancing switch occupies a large chip area because the element consists of a high voltage element having a large size, such as an enhancement driver depletion load MOS (EDMOS)/lateral double diffused MOS (LDMOS).

Furthermore, there is a problem in that there is a difficulty in mass-production management and design due to a non-uniform channel construction because a NMOS is not used at the top of a battery and a PMOS is not used at the bottom of the battery.

Various embodiments are directed to providing a cell balancing device which suppresses the leakage current of a balancing switch that is connected in parallel to battery cells and blocks an operation of the balancing switch when a reverse voltage occurs in a corresponding channel, while not using a high voltage element.

In order to solve the above problem, a device is provided according to the independent claim 1. Preferred embodiments are defined by the dependent claims. According to the main embodiment, among others, a cell balancing device includes a balancing switching unit in which source stages of a first switch and a second switch are connected in series in common and drain stages of the first switch and the second switch are connected in parallel to both ends of a battery cell, respectively, a latch unit interposed between the source stage of the balancing switching unit and a sensing pin of the battery cell and configured to drive a balancing switching unit by outputting a driving voltage to a gate stage of the balancing switching unit by receiving an enable signal and an inversion enable signal, and a reverse voltage protection unit interposed between the source stage of the balancing switching unit and the sensing pin of the battery cell.

In an embodiment, the reverse voltage protection unit may include a protection resistor or a backward Zener diode.

In the present invention, in the latch unit, a first PMOS and a first NMOS are interposed in series between the sensing pin and the source stage of the balancing switching unit, a second PMOS and a second NMOS are interposed in series between the sensing pin and the source stage of the balancing switching unit, a gate stage of the first PMOS and a source stage of the second PMOS are connected, a gate stage of the second PMOS and a source stage of the first PMOS are connected, a common node of the first PMOS and the first NMOS is connected to the gate stage of the balancing switching unit, an inversion enable stage is connected to the gate stage of the first NMOS through a medium of a first high voltage capacitor, and an enable stage is connected to the gate stage of the second NMOS through a medium of a second high voltage capacitor.

In an embodiment, the latch unit may further include a first diode in a backward direction and a first resistor that are interposed between the gate stage of the first NMOS and the source stage of the balancing switching unit, and further includes a second diode in the backward direction and a second resistor that are interposed between the gate stage of the second NMOS and the source stage of the balancing switching unit.

In an embodiment, the latch unit may further include a first Zener diode that is interposed in a backward direction between the gate stage of the first PMOS and the source stage of the balancing switching unit, and further includes a second Zener diode that is interposed in the backward direction between the gate stage of the second PMOS and the source stage of the balancing switching unit.

The cell balancing device may further include a buffer configured to output the driving voltage that is output by the latch unit to the gate stage of the balancing switching unit by buffering the driving voltage.

In an embodiment, the first switch and forward diode of the balancing switching unit may be connected in series and connected in parallel to the both ends of the battery cell, respectively.

The cell balancing device may further include an SR latch configured to output the driving voltage to the gate stage of the balancing switching unit by receiving the driving voltage and an inversion driving voltage that are output by the latch unit..

The cell balancing device according to an aspect of the present disclosure can suppress the leakage current of the balancing switch that is connected in parallel to a battery cell and prevent a failure of the balancing switch by blocking an operation of the balancing switch when a reverse voltage occurs in a corresponding channel, while not using a high voltage element, and facilitates a design and mass production and can reduce a circuit area because the switching driver circuit is constructed by using a common MOS element so that all channels can be constructed in the same form.

### BRIEF DESCRIPTION OF THE DRAWINGS

FIG. 1 is a circuit diagram illustrating a cell balancing device according to the present invention.
FIG. 2 is a circuit diagram illustrating a cell balancing device according to a preferred embodiment.
FIG. 3 is a circuit diagram illustrating a cell balancing device according to another preferred embodiment.
FIG. 4 is a circuit diagram illustrating a cell balancing device according to yet another preferred embodiment.

### DETAILED DESCRIPTION OF THE ILLUSTRATED EMBODIMENTS

The components described in the example embodiments may be implemented by hardware components including, for example, at least one digital signal processor (DSP), a processor, a controller, an application-specific integrated circuit (ASIC), a programmable logic element, such as an FPGA, other electronic devices, or combinations thereof. At least some of the functions or the processes described in the example embodiments may be implemented by software, and the software may be recorded on a recording medium. The components, the functions, and the processes described in the example embodiments may be implemented by a combination of hardware and software.

Various techniques described herein may be implemented as digital electronic circuitry, or as computer hardware, firmware, software, or combinations thereof. The techniques may be implemented as a computer program product, i.e., a computer program tangibly embodied in an information carrier, e.g., in a machine-readable storage device (for example, a computer-readable medium) or in a propagated signal for processing by, or to control an operation of a data processing apparatus, e.g., a programmable processor, a computer, or multiple computers. A computer program(s) may be written in any form of a programming language, including compiled or interpreted languages and may be deployed in any form including a stand-alone program or a module, a component, a subroutine, or other units suitable for use in a computing environment. A computer program may be deployed to be executed on one computer or on multiple computers at one site or distributed across multiple sites and interconnected by a communication network.

Processors suitable for execution of a computer program include, by way of example, both general and special purpose microprocessors, and any one or more processors of any kind of digital computer. Generally, a processor will receive instructions and data from a read-only memory or a random access memory or both. Elements of a computer may include at least one processor to execute instructions and one or more memory devices to store instructions and data. Generally, a computer will also include or be coupled to receive data from, transfer data to, or perform both on one or more mass storage devices to store data, e.g., magnetic, magneto-optical disks, or optical disks. Examples of information carriers suitable for embodying computer program instructions and data include semiconductor memory devices, for example, magnetic media such as a hard disk, a floppy disk, and a magnetic tape, optical media such as a compact disk read only memory (CD-ROM), a digital video disk (DVD), etc. and magneto-optical media such as a floptical disk, and a read only memory (ROM), a random access memory (RAM), a flash memory, an erasable programmable ROM (EPROM), and an electrically erasable programmable ROM (EEPROM) and any other known computer readable medium. A processor and a memory may be supplemented by, or integrated into, a special purpose logic circuit.

The processor may run an operating system (OS) and one or more software applications that run on the OS. The processor device also may access, store, manipulate, process, and create data in response to execution of the software. For purpose of simplicity, the description of a processor device is used as singular; however, one skilled in the art will be appreciated that a processor device may include multiple processing elements and/or multiple types of processing elements. For example, a processor device may include multiple processors or a processor and a controller. In addition, different processing configurations are possible, such as parallel processors.

Also, non-transitory computer-readable media may be any available media that may be accessed by a computer, and may include both computer storage media and transmission media.

The present specification includes details of a number of specific implements, but it should be understood that the details do not limit any invention or what is claimable in the specification but rather describe features of the specific example embodiment. Features described in the specification in the context of individual example embodiments may be implemented as a combination in a single example embodiment. In contrast, various features described in the specification in the context of a single example embodiment may be implemented in multiple example embodiments individually or in an appropriate sub-combination. Furthermore, the features may operate in a specific combination and may be initially described as claimed in the combination, but one or more features may be excluded from the claimed combination in some cases, and the claimed combination may be changed into a sub-combination or a modification of a sub-combination. However, the scope of protection is solely defined by the appended claims.

Similarly, even though operations are described in a specific order on the drawings, it should not be understood as the operations needing to be performed in the specific order or in sequence to obtain desired results or as all the operations needing to be performed. In a specific case, multitasking and parallel processing may be advantageous. In addition, it should not be understood as requiring a separation of various apparatus components in the above described example embodiments in all example embodiments, and it should be understood that the above-described program components and apparatuses may be incorporated into a single software product or may be packaged in multiple software products.

It should be understood that the example embodiments disclosed herein are merely illustrative and are not intended to limit the scope of the invention.

Hereinafter, with reference to the accompanying drawings, embodiments of the present disclosure will be described in detail so that a person skilled in the art can readily carry out the present disclosure. However, the present disclosure may be embodied in many different forms and is not limited to the embodiments described herein.

In the following description of the embodiments of the present disclosure, a detailed description of known functions and configurations incorporated herein will be omitted when it may make the subject matter of the present disclosure rather unclear. Parts not related to the description of the present disclosure in the drawings are omitted, and like parts are denoted by similar reference numerals.

In the present disclosure, components that are distinguished from each other are intended to clearly illustrate each feature. However, it does not necessarily mean that the components are separate. That is, a plurality of components may be integrated into one hardware or software unit, or a single component may be distributed into a plurality of hardware or software units. Thus, unless otherwise noted, such integrated or distributed embodiments are also included within the scope of the present disclosure.

In the present disclosure, components described in the various embodiments are not necessarily essential components, and some may be optional components. Accordingly, embodiments consisting of a subset of the components described in one embodiment are also included within the scope of the present disclosure. In addition, embodiments that include other components in addition to the components described in the various embodiments are also included in the scope of the present disclosure.

Hereinafter, with reference to the accompanying drawings, embodiments of the present disclosure will be described in detail so that a person skilled in the art can readily carry out the present disclosure. However, the present disclosure may be embodied in many different forms and is not limited to the embodiments described herein.

In the following description of the embodiments of the present disclosure, a detailed description of known functions and configurations incorporated herein will be omitted when it may make the subject matter of the present disclosure rather unclear. Parts not related to the description of the present disclosure in the drawings are omitted, and like parts are denoted by similar reference numerals.

In the present disclosure, when a component is referred to as being "linked," "coupled," or "connected" to another component, it is understood that not only a direct connection relationship but also an indirect connection relationship through an intermediate component may also be included. In addition, when a component is referred to as "comprising" or "having" another component, it may mean further inclusion of another component not the exclusion thereof, unless explicitly described to the contrary.

In the present disclosure, the terms first, second, etc. are used only for the purpose of distinguishing one component from another, and do not limit the order or importance of components, etc., unless specifically stated otherwise. Thus, within the scope of this disclosure, a first component in one exemplary embodiment may be referred to as a second component in another embodiment, and similarly a second component in one exemplary embodiment may be referred to as a first component.

In the present disclosure, components that are distinguished from each other are intended to clearly illustrate each feature. However, it does not necessarily mean that the components are separate. That is, a plurality of components may be integrated into one hardware or software unit, or a single component may be distributed into a plurality of hardware or software units. Thus, unless otherwise noted, such integrated or distributed embodiments are also included within the scope of the present disclosure.

In the present disclosure, components described in the various embodiments are not necessarily essential components, and some may be optional components. Accordingly, embodiments consisting of a subset of the components described in one embodiment are also included within the scope of the present disclosure. In addition, exemplary embodiments that include other components in addition to the components described in the various embodiments are also included in the scope of the present disclosure.

Hereinafter, a cell balancing device according to embodiments of the present disclosure will be described with reference to the accompanying drawings. In this process, the thicknesses of lines or the sizes of components illustrated in the drawings may have been exaggerated for the clarity of a description and for convenience' sake. Terms to be described below have been defined by taking into consideration their functions in the present disclosure, and may be changed depending on a user or operator's intention or practice. Accordingly, such terms should be defined based on the overall contents of this specification.

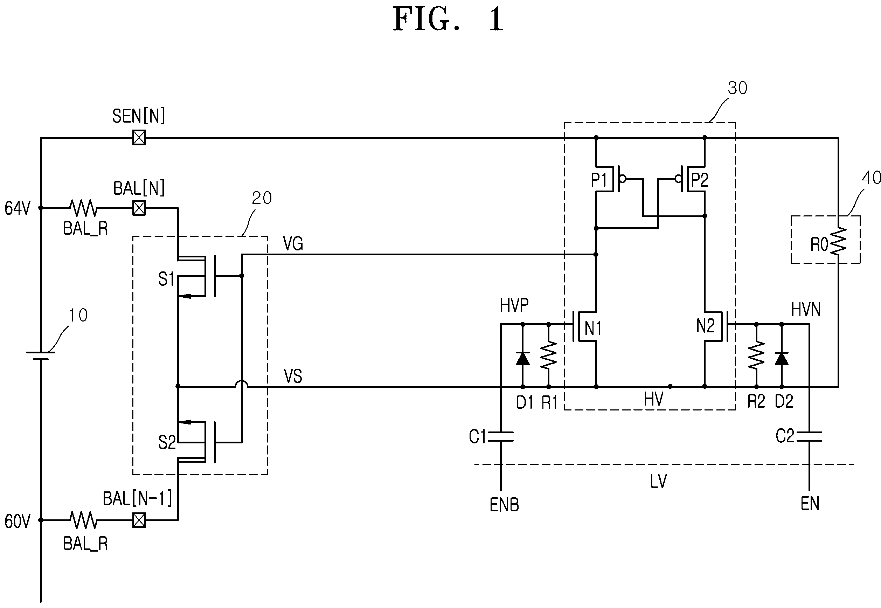

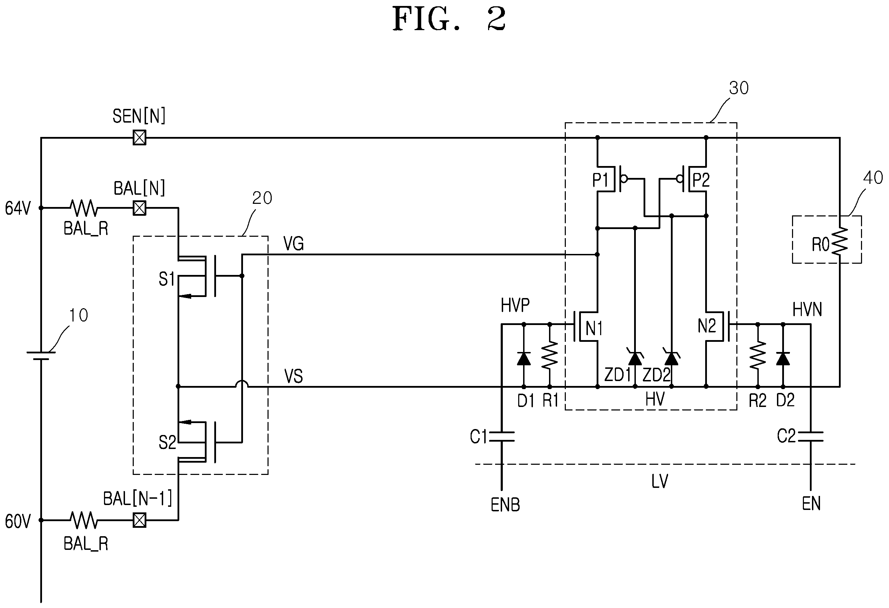

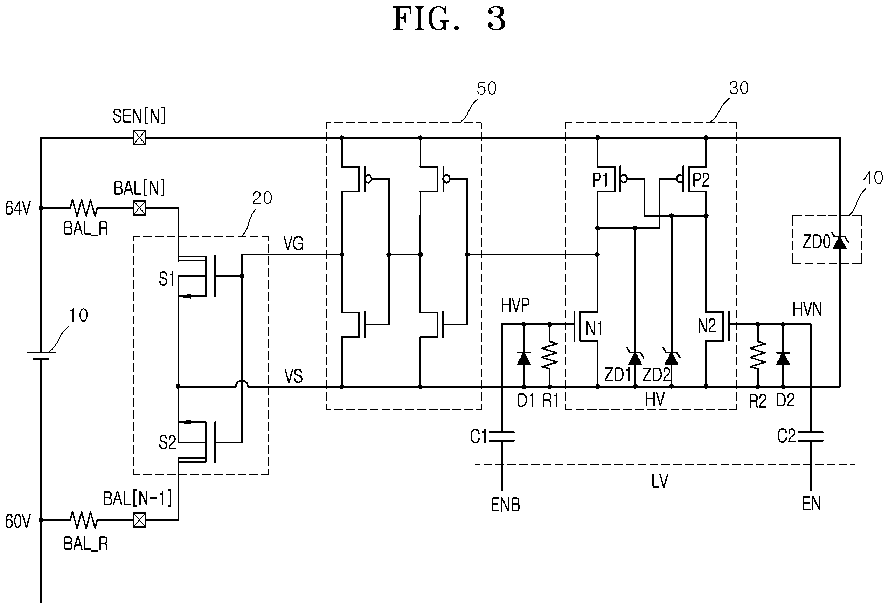

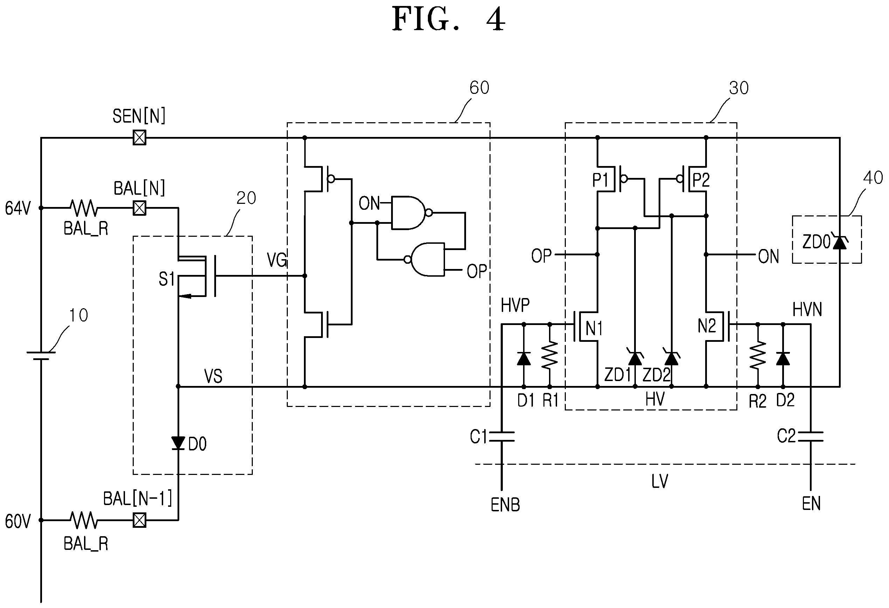

FIG. 1 is a circuit diagram illustrating a cell balancing device according to the present invention. FIG. 2 is a circuit diagram illustrating a cell balancing device according to a preferred embodiment. FIG. 3 is a circuit diagram illustrating a cell balancing device according to another preferred embodiment. FIG. 4 is a circuit diagram illustrating a cell balancing device according to yet another preferred embodiment.

As illustrated in FIGS. 1 to 4, the cell balancing device may include a buffer and an SR latch, in addition to a balancing switching unit 20, a latch unit 30, and a reverse voltage protection unit 40.

As illustrated in FIG. 1, the balancing switching unit 20 is constructed so that source stages VS of a first switch S1 and a second switch S2 are connected in series in common and drain stages of the first switch and the second switch are connected in parallel to both ends BAL[N] and BAL[N-1] of a battery cell 10, respectively, and thus can suppress the leakage current of the balancing switching unit when a reverse voltage occurs in a corresponding channel.

In this case, balancing resistors BAL_R may be connected between both ends BAL[N] and BAL[N-1] of the battery cell 10, respectively, and the balancing switching unit 20. When the balancing switching unit 20 is electrified, a current that is output by the battery cell 10 flows into the balancing resistors BAL_R. Accordingly, the voltage of the battery cell 10 can be reduced because the battery cell 10 that has been charged to have a reference voltage value or more is discharged.

As illustrated in FIG. 4, a forward diode D0 may be constructed instead of the second switch S2 of the balancing switching unit 20 in order to suppress the leakage current of the balancing switching unit in accordance with the reverse voltage.

The latch unit 30 is interposed between the source stage VS of the balancing switching unit 20 and a sensing pin SEN[N] of the battery cell 10, and drives the balancing switching unit 20 by outputting a driving voltage to a gate stage VG of the balancing switching unit 20 by receiving an enable signal EN and an inversion enable signal ENB.

In this case, a first PMOS P1 and first NMOS N1 of the latch unit 30 are interposed in series between the sensing pin SEN[N] and the source stage VS of the balancing switching unit 20. A second PMOS P2 and second NMOS N2 of the latch unit 30 are interposed in series between the sensing pin SEN[N] and the source stage VS of the balancing switching unit 20.

In this case, a gate stage of the first PMOS P1 and a source stage of the second PMOS P2 are connected. A gate stage of the second PMOS P2 and a source stage of the first PMOS P1 are connected. A common node of the first PMOS P1 and the first NMOS N1 is connected to the gate stage VG of the balancing switching unit 20. The inversion enable stage ENB is connected to a gate stage of the first NMOS N1 through a medium of a first high voltage capacitor C1. The enable stage EN is connected to a gate stage of the second NMOS N2 through a medium of a second high voltage capacitor C2.

In this case, the first high voltage capacitor C1 and the second high voltage capacitor C2 may transmit, to a region for a high voltage HV, the enable signal EN and the inversion enable signal ENB each having a low voltage LV, respectively.

Furthermore, the latch unit 30 may further include a first diode D1 in a backward direction and a first resistor R1, which are interposed between the gate stage of the first NMOS N1 and the source stage VS of the balancing switching unit 20, and may further include a second diode D2 in a backward direction and a second resistor R2, which are interposed between the gate stage of the second NMOS N2 and the source stage VS of the balancing switching unit 20.

In this case, the first and second resistors R1 and R2 and the first and second diodes D1 and D2 may adjust the voltages of HVP and HVN nodes, that is, the gate stages of the first and second NMOSs N1 and N2, respectively, to a lower voltage of the battery cell 10.

Accordingly, the latch unit 30 may drive the balancing switching unit 20 by outputting a driving voltage that generates a difference between the voltages of the gate stage VG and source stage VS of the balancing switching unit 20 by separating peak voltage signals that are input to the HVP and HVN nodes in response to the enable signal EN and the inversion enable signal ENB, respectively.

Furthermore, as illustrated in FIG. 2, the latch unit 30 may further include a first Zener diode ZD1 that is interposed in a backward direction between the gate stage of the first PMOS P1 and the source stage VS of the balancing switching unit 20, and may further include a second Zener diode ZD2 that is interposed in a backward direction between the gate stage of the second PMOS P2 and the source stage VS of the balancing switching unit 20. Accordingly, the latch unit 30 can protect an element within the latch unit 30 by preventing internal voltages of the latch unit 30 from having a predetermined difference or more when the battery cell 10 is mounted or detached or although an abnormal operation occurs in the battery cell 10.

The reverse voltage protection unit 40 is interposed between the source stage VS of the balancing switching unit 20 and the sensing pin SEN[N] of the battery cell 10, and may stop an operation of the balancing switching unit 20 when a reverse voltage occurs in a corresponding channel and may adjust the voltage of the source stage VS of the balancing switching unit 20 to the voltage of the sensing pin SEN[N] in order to suppress a leakage current of the balancing switching unit.

In this case, the reverse voltage protection unit 40 may be constructed by using a protection resistor R0 illustrated in FIG. 1, and may be constructed by using a backward Zener diode ZD0 in order to reduce the area of the reverse voltage protection unit 40 as illustrated in FIG. 3.

As illustrated in FIG. 3, a buffer 50 may be added between the latch unit 30 and the balancing switching unit 20.

The buffer 50 may buffer a driving voltage that is output by the latch unit 30 and output the buffered voltage to the gate stage VG of the balancing switching unit 20 in order to increase an operating speed of the latch unit 30 by reducing a load of the latch unit 30.

Furthermore, as illustrated in FIG. 4, an SR latch 60, that is, a digital logic circuit, may be added between the latch unit 30 and the balancing switching unit 20.

The SR latch 60 may receive a driving voltage OP and an inversion driving voltage ON that are output by the latch unit 30 and output the driving voltage to the gate stage VG of the balancing switching unit 20 in order to disconnect feedback between the source stage VS and gate stage VG of the balancing switching unit 20 and increase noise resistivity.

The constructions of the balancing switching unit 20, the latch unit 30, the buffer 50, the SR latch 60, and the reverse voltage protection unit 40 according to the embodiments of the cell balancing devices illustrated in FIGS. 1 to 4 may be applied in a cross way.

As described above, according to the cell balancing devices according to the embodiments of the present disclosure, the leakage current of the balancing switch that is connected in parallel to the battery cell can be suppressed while not using a high voltage element. A failure of the balancing switch can be prevented by blocking an operation of the balancing switch when a reverse voltage occurs in a corresponding channel. A design and mass production are facilitated and a circuit area can be reduced because all channels can be constructed in the same form by constructing the switching driver circuit by using a common MOS element.

The present invention has been described above with reference to the embodiments illustrated in the accompanying drawings, but the embodiments are merely illustrative. A person having ordinary knowledge in the art to which the present invention pertains will understand that various modifications are possible from the embodiments.

Accordingly, the true technical range of protection of the present invention are determined by the claims.

## Claims

1. A cell balancing device comprising:
a balancing switching unit (20) comprising a first switch (S1) and a second switch (S2) connected in series with their respective sources connected together to form a common source stage (VS), and wherein respective drain stages of the first switch (S1) and the second switch (S2) are connected in parallel to both ends of a battery cell (10);
balancing resistors (BAL_R) interposed between the both ends (BAL[N]), BAL[N-1]) of the battery cell (10), respectively, and the balancing switching unit (20);
a latch unit (30) interposed between the source stage of the balancing switching unit (20) and a sensing pin of the battery cell (10) and configured to drive a balancing switching unit (20) by outputting a driving voltage to a gate stage (VG) of the balancing switching unit (20) by receiving an enable signal (EN) and an inversion enable signal (ENB); and
a reverse voltage protection unit (40) interposed between the source stage (VS) of the balancing switching unit (20) and the sensing pin of the battery cell (10),
wherein in the latch unit (30),
a first PMOS (P1) and a first NMOS (N1) are interposed in series between the sensing pin and the source stage (VS) of the balancing switching unit (20),
a second PMOS (P2) and a second NMOS (N2) are interposed in series between the sensing pin and the source stage (VS) of the balancing switching unit (20),
a gate stage of the first PMOS (P1) and a source stage of the second PMOS (P2) are connected,
a gate stage of the second PMOS (P2) and a source stage of the first PMOS (P1) are connected,
a common node of the first PMOS (P1) and the first NMOS (N1) is connected to the gate stage (VG) of the balancing switching unit (20),
an inversion enable stage (ENB) is connected to the gate stage of the first NMOS (N1) through a medium of a first high voltage capacitor (C1), and
an enable stage (EN) is connected to the gate stage of the second NMOS (N2) through a medium of a second high voltage capacitor (C2).

2. The cell balancing device of claim 1, wherein the reverse voltage protection unit (40) comprises a protection resistor (R0) or a backward Zener diode (ZD0).

3. The cell balancing device of claim 1 or 2, wherein:
the latch unit (30) further comprises a first diode (D1) in a backward direction and a first resistor (R1) that are interposed between the gate stage of the first NMOS (N1) and the source stage of the balancing switching unit (20), and
the latch unit (30) further comprises a second diode (D2) in the backward direction and a second resistor (R2) that are interposed between the gate stage of the second NMOS (N2) and the source stage of the balancing switching unit (20).

4. The cell balancing device of claim 1 or 2, wherein:
the latch unit (30) further comprises a first Zener diode (ZD1) that is interposed in a backward direction between the gate stage of the first PMOS (P1) and the source stage of the balancing switching unit (20), and
the latch unit (30) further comprises a second Zener diode (ZD2) that is interposed in the backward direction between the gate stage of the second PMOS (P2) and the source stage of the balancing switching unit (20).

5. The cell balancing device of any one of claims 1 to 4, further comprising a buffer (50) configured to output the driving voltage that is output by the latch unit (30) to the gate stage (VG) of the balancing switching unit (20) by buffering the driving voltage.

6. The cell balancing device of any one of claims 1 to 5, further comprising an SR latch (60) configured to output the driving voltage to the gate stage (VG) of the balancing switching unit (20) by receiving the driving voltage and an inversion driving voltage that are output by the latch unit (30).

## Patentansprüche

1. Zellenausgleichsvorrichtung, aufweisend:
eine Ausgleichsschalteinheit (20), aufweisend einen ersten Schalter (S1) und einen zweiten Schalter (S2), die in Reihe geschaltet sind, wobei ihre jeweiligen Source-Anschlüsse miteinander verbunden sind, um eine gemeinsame Source-Stufe (VS) zu bilden, und wobei jeweilige Drain-Stufen des ersten Schalters (S1) und des zweiten Schalters (S2) mit beiden Enden einer Batteriezelle (10) parallel geschaltet sind;
Ausgleichswiderstände (BAL_R), die jeweils zwischen den beiden Enden (BAL[N]), BAL[N-1]) der Batteriezelle (10) und der Ausgleichsschalteinheit (20) angeordnet sind;
eine Latch-Einheit (30), die zwischen der Source-Stufe der Ausgleichsschalteinheit (20) und einem Erfassungsstift der Batteriezelle (10) angeordnet und konfiguriert ist, um eine Ausgleichsschalteinheit (20) anzusteuern, durch Ausgeben einer Ansteuerspannung an eine Gate-Stufe (VG) der Ausgleichsschalteinheit (20)durch Empfangen eines Freigabesignals (EN) und eines Inversionsfreigabesignals (ENB); und
eine Rückwärtsspannungsschutzeinheit (40), die zwischen der Source-Stufe (VS) der Ausgleichsschalteinheit (20) und dem Erfassungsstift der Batteriezelle (10) angeordnet ist,
wobei in der Latch-Einheit (30),
ein erster PMOS (P1) und ein erster NMOS (N1) in Reihe zwischen dem Erfassungsstift und der Source-Stufe (VS) der Ausgleichsschalteinheit (20) angeordnet sind,
ein zweiter PMOS (P2) und ein zweiter NMOS (N2) in Reihe zwischen dem Erfassungsstift und der Source-Stufe (VS) der Ausgleichsschalteinheit (20) angeordnet sind,
eine Gate-Stufe des ersten PMOS (P1) und eine Source-Stufe des zweiten PMOS (P2) verbunden sind,
eine Gate-Stufe des zweiten PMOS (P2) und eine Source-Stufe des ersten PMOS (P1) verbunden sind,
ein gemeinsamer Knoten des ersten PMOS (P1) und des ersten NMOS (N1) mit der Gate-Stufe (VG) der Ausgleichsschalteinheit (20) verbunden ist,
eine Inversionsfreigabestufe (ENB) mit der Gate-Stufe des ersten NMOS (N1) mittels eines ersten Hochspannungskondensators (C1) verbunden ist, und
eine Freigabestufe (EN) mit der Gate-Stufe des zweiten NMOS (N2) mittels eines zweiten Hochspannungskondensators (C2) verbunden ist.

2. Zellenausgleichsvorrichtung nach Anspruch 1, wobei die Rückwärtsspannungsschutzeinheit (40) einen Schutzwiderstand (R0) oder eine Rückwärts-Zenerdiode (ZD0) aufweist.

3. Zellausgleichsvorrichtung nach Anspruch 1 oder 2, wobei:
die Latch-Einheit (30) ferner eine erste Diode (D1) in einer Rückwärtsrichtung und einen ersten Widerstand (R1) aufweist, die zwischen der Gate-Stufe des ersten NMOS (N1) und der Source-Stufe der Ausgleichsschalteinheit (20) angeordnet sind, und
die Latch-Einheit (30) ferner eine zweite Diode (D2) in der Rückwärtsrichtung und einen zweiten Widerstand (R2) aufweist, die zwischen der Gate-Stufe des zweiten NMOS (N2) und der Source-Stufe der Ausgleichsschalteinheit (20) angeordnet sind.

4. Zellausgleichsvorrichtung nach Anspruch 1 oder 2, wobei:
die Latch-Einheit (30) ferner eine erste Zenerdiode (ZD1) aufweist, die in einer Rückwärtsrichtung zwischen der Gate-Stufe des ersten PMOS (P1) und der Source-Stufe der Ausgleichsschalteinheit (20) angeordnet ist, und
die Latch-Einheit (30) ferner eine zweite Zenerdiode (ZD2) aufweist, die in Rückwärtsrichtung zwischen der Gate-Stufe des zweiten PMOS (P2) und der Source-Stufe der Ausgleichsschalteinheit (20) angeordnet ist.

5. Zellenausgleichsvorrichtung nach einem der Ansprüche 1 bis 4, ferner aufweisend einen Puffer (50), der konfiguriert ist, um die Ansteuerspannung, die von der Verriegelungseinheit (30) ausgegeben wird, an die Gate-Stufe (VG) der Ausgleichsschalteinheit (20) auszugeben, durch Puffern der Ansteuerspannung.

6. Zellausgleichsvorrichtung nach einem der Ansprüche 1 bis 5, ferner aufweisend ein SR-Latch (60), das konfiguriert ist, um die Ansteuerspannung an die Gate-Stufe (VG) der Ausgleichsschalteinheit (20) auszugeben, durch Empfangen der Ansteuerspannung und einer Inversionsansteuerspannung, die von der Verriegelungseinheit (30) ausgegeben werden.

## Revendications

1. Dispositif d'équilibrage d'élément comprenant :
une unité de commutation d'équilibrage (20) comprenant un premier commutateur (S1) et un second commutateur (S2) connectés en série avec leurs sources respectives connectées ensemble pour former un étage source commun (VS), et dans lequel des étages de drain respectifs du premier commutateur (S1) et du second commutateur (S2) sont connectés en parallèle aux deux extrémités d'un élément de batterie (10) ;
des résistances d'équilibrage (BAL_R) interposées entre les deux extrémités (BAL[N]), BAL[N-1]) de l'élément de batterie (10), respectivement, et l'unité de commutation d'équilibrage (20) ;
une unité de verrouillage (30) interposée entre l'étage source de l'unité de commutation d'équilibrage (20) et une broche de détection de l'élément de batterie (10) et configurée pour exciter une unité de commutation d'équilibrage (20) en délivrant une tension d'excitation vers un étage de grille (VG) de l'unité de commutation d'équilibrage (20) en recevant un signal d'activation (EN) et un signal d'activation d'inversion (ENB) ; et
une unité de protection contre les tensions inverses (40) interposée entre l'étage source (VS) de l'unité de commutation d'équilibrage (20) et la broche de détection de l'élément de batterie (10),
dans lequel, dans l'unité de verrouillage (30),
un premier PMOS (P1) et un premier NMOS (N1) sont interposés en série entre la broche de détection et l'étage source (VS) de l'unité de commutation d'équilibrage (20),
un second PMOS (P2) et un second NMOS (N2) sont interposés en série entre la broche de détection et l'étage source (VS) de l'unité de commutation d'équilibrage (20),
un étage de grille du premier PMOS (P1) et un étage source du second PMOS (P2) sont connectés,
un étage de grille du second PMOS (P2) et un étage source du premier PMOS (P1) sont connectés,
un nœud commun du premier PMOS (P1) et du premier NMOS (N1) est connecté à l'étage de grille (VG) de l'unité de commutation d'équilibrage (20),
un étage d'activation d'inversion (ENB) est connecté à l'étage de grille du premier NMOS (N1) par l'intermédiaire d'un premier condensateur à haute tension (C1), et
un étage d'activation (EN) est connecté à l'étage de grille du second NMOS (N2) par l'intermédiaire d'un second condensateur à haute tension (C2).

2. Dispositif d'équilibrage d'élément selon la revendication 1, dans lequel l'unité de protection contre les tensions inverses (40) comprend une résistance de protection (R0) ou une diode Zener inversée (ZD0).

3. Dispositif d'équilibrage d'élément selon la revendication 1 ou 2, dans lequel :
l'unité de verrouillage (30) comprend en outre une première diode (D1) dans un sens inverse et une première résistance (R1) qui sont interposées entre l'étage de grille du premier NMOS (N1) et l'étage source de l'unité de commutation d'équilibrage (20), et
l'unité de verrouillage (30) comprend en outre une seconde diode (D2) dans le sens inverse et une seconde résistance (R2) qui sont interposées entre l'étage de grille du second NMOS (N2) et l'étage source de l'unité de commutation d'équilibrage (20).

4. Dispositif d'équilibrage d'élément selon la revendication 1 ou 2, dans lequel :
l'unité de verrouillage (30) comprend en outre une première diode Zener (ZD1) qui est interposée dans un sens inverse entre l'étage de grille du premier PMOS (P1) et l'étage source de l'unité de commutation d'équilibrage (20), et
l'unité de verrouillage (30) comprend en outre une seconde diode Zener (ZD2) qui est interposée dans le sens inverse entre l'étage de grille du second PMOS (P2) et l'étage source de l'unité de commutation d'équilibrage (20).

5. Dispositif d'équilibrage d'élément selon l'une quelconque des revendications 1 à 4, comprenant en outre un tampon (50) configuré pour délivrer la tension d'excitation qui est délivrée par l'unité de verrouillage (30) vers l'étage de grille (VG) de l'unité de commutation d'équilibrage (20) en mettant en mémoire tampon la tension d'excitation.

6. Dispositif d'équilibrage d'élément selon l'une quelconque des revendications 1 à 5, comprenant en outre un verrou SR (60) configuré pour délivrer la tension d'excitation à l'étage de grille (VG) de l'unité de commutation d'équilibrage (20) en recevant la tension d'excitation et une tension d'excitation d'inversion qui sont délivrées par l'unité de verrouillage (30).
